# EUROPÄISCHE PATENTSCHRIFT

(11) **EP 3 564 696 B1**
(45) Veröffentlichungstag und Bekanntmachung des Hinweises auf die Patenterteilung: **01.03.2023**
(21) Anmeldenummer: 19165692.5
(22) Anmeldetag: 28.03.2019
(51) Int. Cl.: G01R 35/02, G01R 15/14, G01R 19/25

(54) **VERFAHREN ZUM MESSEN VON STRÖMEN AN MEHREREN MESSSTELLEN EINES STROMNETZES MITTELS STROMWANDLER-MESSKOMBINATIONEN UND STROMWANDLER-MESSKOMBINATION ZUR DURCHFÜHRUNG DES VERFAHRENS**
METHOD FOR MEASURING CURRENTS AT MULTIPLE MEASURING POINTS OF A POWER NETWORK USING CONVERTER-MEASUREMENT COMBINATIONS AND CONVERTER-MEASUREMENT COMBINATION FOR CARRYING OUT THE METHOD
PROCÉDÉ DE MESURE DES FLUX SUR UNE PLURALITÉ DE SITES DE MESURE D'UN RÉSEAU ÉLECTRIQUE AU MOYEN DES COMBINAISONS DE MESURE DE TRANSFORMATEUR DE COURANT ET COMBINAISON DE MESURE DE TRANSFORMATEUR DE COURANT DESTINÉE À LA MISE EN UVRE DUDIT PROCÉDÉ

(30) Priorität: 26.04.2018 DE 102018206456
(43) Veröffentlichungstag der Anmeldung: 06.11.2019
(73) Patentinhaber: Siemens Aktiengesellschaft, 80333 München (DE)
(72) Erfinder: Haspel, Markus, 90429 Nürnberg (DE)

(56) Entgegenhaltungen:
- CN-U- 206 460 103
- DE-A1- 19 736 602
- US-A1- 2005 288 877
- US-B1- 6 671 635

## Beschreibung

Die Erfindung betrifft ein Verfahren mit Stromwandler-Messkombinationen und eine entsprechende Stromwandler-Messkombination zur Durchführung des Verfahrens gemäß den Oberbegriffen der Ansprüche 1 und 3.

Es ist bekannt, elektrische Ströme innerhalb eines Stromnetzes an mehreren Messstellen zu messen. Dazu werden Stromwandler-Messkombinationen verwendet, zu denen jeweils ein Stromwandler und eine Messeinrichtung gehört, die elektrisch miteinander verbunden sind. Dabei wandelt der bezogen auf die Messeinrichtung externe Stromwandler den nicht direkt messbaren (sehr großen) Strom, der durch einen der Stromleiter des Stromnetzes fließt, in einen kleineren Strom um, welcher der Messeinrichtung zugeführt wird. Dazu ist der Stromwandler mit einem Eingang der Messeinrichtung verbunden und der Wandlerausgangsstrom fließt jeweils über den Eingang der Messeinrichtung. Üblicherweise bestimmt die Genauigkeit des Stromwandlers die Genauigkeit der von der Messeinrichtung ermittelten Strommesswerte wesentlich mit. Weiter unterscheiden sich die Stromwandler in ihrer technischen Ausführung oft deutlich voneinander, weshalb für einzelne Stromwandler-Typen jeweils ein zugehöriger Messeingang an der Messeinrichtung vorhanden ist. Die Messeinrichtung hat also oft mehrere individuelle Eingänge für die sich typenmäßig unterscheidenden Stromwandler. Die einzelnen Stromwandler unterscheiden sich auch hinsichtlich ihrer Genauigkeit oder sind mit unterschiedlicher Genauigkeit verfügbar. Aus Kostengründen werden oft Stromwandler mit geringerer Genauigkeit eingesetzt, obwohl eigentlich eine höhere Genauigkeit der Strommesswerte gewünscht ist.

Weiterhin offenbart die US 6,671,635 B1 ein System zur verbesserten Überwachung von einer Genauigkeit von intelligenten elektronischen Vorrichtungen. Darüber hinaus offenbart die US 2005/0288877 A1 ein Verfahren und ein Gerät für eine Instrumentenwandlerreklassifikation. Aus der DE 197 36 602 A1 ist ferner eine Stromwandlereinrichtung bekannt.

Der Nachteil der bekannten Stromwandler-Messkombinationen besteht darin, dass eine hohe Genauigkeit der Messwerte genauere Stromwandler erfordert, die aber deutlich teurer sind.

Die Aufgabe der Erfindung ist es, eine Stromwandler-Messkombination vorzuschlagen, die günstigere Stromwandler verwendet und trotzdem eine höhere Genauigkeit erzielt. Weiter besteht die Aufgabe in einem Verfahren zum Messen von Strömen unter Verwendung einer solchen Stromwandler-Messkombination.

Die Aufgabe wird bezogen auf das Verfahren durch die Merkmale des Anspruchs 1 und bezogen auf die Stromwandler-Messkombination durch die Merkmale des Anspruchs 3 gelöst; der Unteranspruch stellt eine vorteilhafte Ausgestaltung dar.

Die Aufgabe wird bezogen auf das Verfahren dadurch gelöst, dass jede Messeinrichtung einer Stromwandler-Messkombination einen zweiten Eingang aufweist, an den ein zweiter Stromwandler zeitweise anschließbar ist, von dem der Strom mit einer größeren Genauigkeit als vom ersten DC-Stromwandler in einen proportionalen Wandlerausgangsstrom gewandelt wird, dass der zweite Stromwandler jeweils an derselben Messstelle wie der erste Stromwandler der Messeinrichtung angeordnet, mit dem zweiten Eingang verbunden und eine Vergleichsmessung durchgeführt wird, dass die mittels der beiden Stromwandler ermittelten Strommesswerte miteinander verglichen werden, indem für die Messung mit dem ersten Stromwandler ein Korrekturkennwert ermittelt und jeweils für die Messung des ersten Stromwandlers verwendet wird.

Die Lösung sieht bezogen auf die Stromwandler-Messkombination vor, dass die Messeinrichtung einen zweiten Eingang aufweist, an den ein zweiter Stromwandler anschließbar ist, der den DC-Strom mit einer größeren Genauigkeit als der erste Stromwandler in einen proportionalen Wandlerausgangsstrom wandelt, dass der zweite Stromwandler zeitweise an derselben Messstelle des Stromleiters wie der erste DC-Stromwandler angeordnet und an den zweiten Eingang angeschlossen ist, so dass dessen Wandlerausgangsstrom über den zweiten Eingang der Messeinrichtung fließt, welche einen zweiten Strommesswert des Stroms ermittelt, dass die Messeinrichtung die beiden so ermittelten Strommesswerte zur Ermittlung eines Korrekturkennwerts verwendet, wenn der zweite Stromwandler am zweiten Eingang der Messeinrichtung angeschlossen ist, und dass anhand des Korrekturkennwerts jeweils eine Korrektur des gemessenen ersten Strommesswerts erfolgt.

Es wird also nur ein einziger Stromwandler mit einer hohen Wandlergenauigkeit benötigt, um eine höhere Genauigkeit bei der Strommessung an verschiedenen Stellen eines Stromnetzes zu erzielen.

Die Erfindung wird nachfolgend anhand eines Ausführungsbeispiels für ein Stromnetz näher beschrieben, das aus miteinander verbundenen Stromleitern gebildet ist, an denen mehrere Messstellen angeordnet sind. Bei dem Stromnetz handelt es sich um ein Gleichstromnetz. An jeder Messstelle befindet sich ein erster Stromwandler, der den an der Messstelle durch den Stromleiter fließenden Strom in einen proportionalen Wandlerausgangsstrom umsetzt, der deutlich kleiner ist als der Strom durch den Stromleiter. Abhängig von der Art des Stromnetzes (Gleichstromnetz) sind die Stromwandler jeweils entsprechend als Gleichwandler ausgebildet. Ein erster Stromwandler ist jeweils mit einem ersten Eingang einer Messeinrichtung verbunden, die zusammen mit dem Stromwandler eine Stromwandler-Messkombination bildet. Anhand des Wandlerausgangsstroms, der über den ersten Eingang durch die Messeinrichtung fließt, wird ein Strommesswert ermittelt.

Jede Messeinrichtung einer Stromwandler-Messkombination weist weiter einen zweiten Eingang für einen zweiten Stromwandler auf. Um die Genauigkeit der Strommesswerte zu erhöhen, die mit Hilfe des ersten Stromwandlers ermittelt werden, wird an dem zweiten Eingang für eine kurze Zeit ein hochgenauer zweiter Stromwandler angeschlossen, d. h. ein zweiter Stromwandler, der eine deutlich höhere Genauigkeit als der erste Stromwandler aufweist. Die Genauigkeit bezieht sich dabei insbesondere auf den Wandlerausgangsstrom im Verhältnis zu dem durch den jeweiligen Stromleiter fließenden Strom. Der zweite Stromwandler wird quasi an derselben Stelle wie der erste Stromwandler an der Leitung angeordnet, hier z.B. unmittelbar daneben, so dass durch den zweiten Stromwandler derselbe Strom wie durch den ersten Stromwandler fließt. Wesentlich ist also, dass der zweite Stromwandler an demselben Stromleiter angeordnet ist und so denselben Strom erfasst, was mit an derselben Stelle gemeint ist. In diesem Sinne ist an derselben Messstelle wie der erste Stromwandler zu verstehen. Auch von diesem zweiten Stromwandler wird anhand des abgegebenen Wandlerausgangsstroms ein zweiter Strommesswert bestimmt. Dieser zweite Strommesswert des zweiten Stromwandlers wird mit dem ersten Strommesswert des ersten Stromwandlers verglichen, in dem für die Messung mit dem ersten Stromwandler ein Korrekturkennwert (z.B. ein Korrekturfaktor) ermittelt wird. Dieser Korrekturkennwert wird jeweils für die Messung des ersten Stromwandlers verwendet.

Der zweite Stromwandler wird nach dem Vergleich wieder von der Messeinrichtung entfernt und zum Vergleich der Strommesswerte einer anderen Messeinrichtung verwendet. Auf diese Weise ist es möglich, die Genauigkeit der ersten Strommesswerte innerhalb eines Stromnetzes zu erhöhen, an denen die Stromwandler-Messkombinationen verwendet werden.

## Patentansprüche

1. Verfahren zum Messen von DC-Strömen an mehreren verschiedenen Messstellen eines Gleichstromnetzes, das aus miteinander verbundenen Stromleitern gebildet wird, an denen erste DC-Stromwandler angeordnet sind, die jeweils den an der Messstelle durch den jeweiligen Stromleiter fließenden DC-Strom in einen proportionalen Wandlerausgangsstrom umsetzen, der jeweils über einen mit dem DC-Stromwandler verbundenen ersten individuellen Eingang einer Messeinrichtung fließt, welche daraus einen jeweiligen Strommesswert ermittelt, wobei der jeweilige erste DC-Stromwandler und die zugehörige Messeinrichtung jeweils eine Stromwandler-Messkombination bilden,
**dadurch gekennzeichnet,**
**dass** jede Messeinrichtung einer jeweiligen Stromwandler-Messkombination einen zweiten individuellen Eingang aufweist, an den ein zweiter Stromwandler zeitweise für eine kurze Zeit anschließbar ist, von dem der DC-Strom mit einer größeren Genauigkeit als vom jeweiligen ersten DC-Stromwandler in einen proportionalen Wandlerausgangsstrom gewandelt wird,
wobei der zweite Stromwandler jeweils an derselben Messstelle wie der erste DC-Stromwandler der Messeinrichtung angeordnet wird und so denselben DC-Strom erfasst, mit dem zweiten individuellen Eingang verbunden und eine Vergleichsmessung durchgeführt wird,
wobei die mittels der beiden Stromwandler ermittelten Strommesswerte miteinander verglichen werden, indem für die Messung mit dem ersten DC-Stromwandler ein Korrekturkennwert ermittelt und jeweils für die Messung des ersten DC-Stromwandlers verwendet wird, wenn der zweite Stromwandler nach dem Vergleich wieder von der jeweiligen Messeinrichtung entfernt wird, so dass nur ein einziger zweiter Stromwandler mit der größeren Wandlergenauigkeit benötigt wird.

2. Verfahren nach Anspruch 1,
**dadurch gekennzeichnet,**
**dass** die mittels der beiden Stromwandler ermittelten Strommesswerte durch einen Algorithmus verglichen werden.

3. Stromwandler-Messkombination für ein Gleichstromnetz, das Stromleiter aufweist, an denen mehrere verschiedenen Messstellen vorhanden sind zur Messung eines DC-Stroms, der durch den zur jeweiligen Messstelle gehörigen Stromleiter fließt, mit einer Messeinrichtung, die einen ersten individuellen Eingang aufweist, welcher mit einem ersten DC-Stromwandler verbunden ist, der an einer jeweiligen Messstelle eines jeweiligen Stromleiters angeordnet ist und dessen Wandlerausgangsstrom über den ersten individuellen Eingang der Messeinrichtung fließt, welche einen ersten Strommesswert des DC-Stroms ermittelt,
**dadurch gekennzeichnet,**
**dass** die Messeinrichtung einen zweiten individuellen Eingang aufweist, an den ein zweiter Stromwandler anschließbar ist, der den DC-Strom mit einer größeren Genauigkeit als der erste DC-Stromwandler in einen proportionalen Wandlerausgangsstrom wandelt,
wobei der zweite Stromwandler zeitweise für eine kurze Zeit an derselben Messstelle des Stromleiters wie der erste DC-Stromwandler angeordnet und an den zweiten individuellen Eingang angeschlossen ist und so denselben DC-Strom erfasst, so dass dessen Wandlerausgangsstrom über den zweiten individuellen Eingang der Messeinrichtung fließt, welche einen zweiten Strommesswert des DC-Stroms ermittelt,
wobei die Messeinrichtung die beiden so ermittelten Strommesswerte zur Ermittlung eines Korrekturkennwerts verwendet, wenn der zweite Stromwandler am zweiten individuellen Eingang der Messeinrichtung angeschlossen ist, und
**dass** anhand des Korrekturkennwerts jeweils eine Korrektur des gemessenen ersten Strommesswerts erfolgt, wenn der zweite Stromwandler nach dem Vergleich wieder von der jeweiligen Messeinrichtung entfernt ist, so dass nur ein einziger zweiter Stromwandler mit der größeren Wandlergenauigkeit benötigt wird.

## Claims

1. Method for measuring DC currents at a plurality of different measurement points of a DC network that is formed from current conductors that are connected to one another, and at which measurement points first DC current transformers are arranged that in each case convert the DC current flowing through the respective current conductor at the measurement point into a proportional transformer output current that in each case flows via a first individual input, which is connected to the DC current transformer, of a measuring apparatus that ascertains a respective current measured value therefrom, wherein the respective first DC current transformer and the associated measuring apparatus in each case form a current transformer-measurement combination,
**characterized**
**in that** each measuring apparatus of a respective current transformer-measurement combination has a second individual input to which a second current transformer can be temporarily connected for a short time, by which the DC current is converted into a proportional transformer output current with greater accuracy than by the respective first DC current transformer,
wherein the second current transformer is in each case arranged at the same measurement point as the first DC current transformer of the measuring apparatus, and therefore captures the same DC current, is connected to the second individual input and a comparison measurement is carried out,
wherein the current measured values ascertained by means of the two current transformers are compared with one another by virtue of a correction characteristic value being ascertained for the measurement with the first DC current transformer and being used in each case for the measurement of the first DC current transformer if the second current transformer is removed again from the respective measuring apparatus following the comparison, with the result that only a single second current transformer with the greater transformer accuracy is required.

2. Method according to Claim 1,
**characterized**
**in that** the current measured values ascertained by means of the two current transformers are compared by an algorithm.

3. Current transformer-measurement combination for a DC network that has current conductors, on which there are a plurality of different measurement points for measuring a DC current that flows through the current conductor belonging to the respective measurement point, comprising a measuring apparatus that has a first individual input that is connected to a first DC current transformer arranged at a respective measurement point of a respective current conductor, and the transformer output current of which flows via the first individual input of the measuring apparatus that ascertains a first current measured value of the DC current,
**characterized**
**in that** the measuring apparatus has a second individual input to which a second current transformer can be connected, which second current transformer converts the DC current into a proportional transformer output current with greater accuracy than the first DC current transformer,
wherein the second current transformer is temporarily arranged for a short time at the same measurement point of the current conductor as the first DC current transformer and is connected to the second individual input, and therefore captures the same DC current, with the result that the transformer output current thereof flows via the second individual input of the measuring apparatus that ascertains a second current measured value of the DC current,
wherein the measuring apparatus uses the two current measured values ascertained in this way to ascertain a correction characteristic value if the second current transformer is connected to the second individual input of the measuring apparatus, and
**in that**, on the basis of the correction characteristic value, in each case a correction is made to the measured first current measured value if the second current transformer is removed again from the respective measuring apparatus following the comparison, with the result that only a single second current transformer with the greater transformer accuracy is required.

## Revendications

1. Procédé de mesure de courants DC en plusieurs emplacements de mesure différents d'un réseau de courant continu qui est constitué de conducteurs liés entre eux, sur lesquels sont disposés de premiers transformateurs DC qui convertissent respectivement le courant qui passe à l'emplacement de mesure par le conducteur respectif en un courant de sortie transformé proportionnel qui passe respectivement par une première entrée individuelle liée au transformateur DC d'un dispositif de mesure, qui détermine à partir de lui une valeur respective de mesure de courant, le premier transformateur DC respectif et le dispositif de mesure correspondant formant respectivement une association transformateur-instrument de mesure,
**caractérisé en ce que**
chaque dispositif de mesure d'une association transformateur-instrument de mesure respective présente une seconde entrée individuelle à laquelle un second transformateur peut être brièvement raccordé temporairement, d'où le courant continu est transformé en un courant de sortie transformé proportionnel avec une plus grande précision que par le premier transformateur DC respectif,
le second transformateur étant disposé au même point de mesure que le premier transformateur DC du dispositif de mesure et donc mesurant le même courant DC, la seconde entrée individuelle étant liée et une mesure comparative étant effectuée,
les valeurs de mesure de courant déterminées par les deux transformateurs étant comparées entre elles, au cours de quoi, pour la mesure avec le premier transformateur DC, un paramètre correctif est déterminé et utilisé respectivement pour la mesure du premier transformateur DC quand le second transformateur est à nouveau éloigné du dispositif de mesure respectif après comparaison, de sorte que seul un unique second transformateur de plus grande précision de transformation soit nécessaire.

2. Procédé selon la revendication 1
**caractérisé en ce que**
les valeurs de mesure de courant déterminées au moyen des deux transformateurs sont comparées par un algorithme.

3. Association transformateur-instrument de mesure pour un réseau de courant continu, qui présente un conducteur sur lequel sont présents plusieurs emplacements de mesure différents pour la mesure d'un courant DC passant par le conducteur correspondant à l'emplacement de mesure respectif, avec un dispositif de mesure qui présente une première entrée individuelle liée à un premier transformateur DC affecté à un emplacement de mesure respectif d'un conducteur respectif et dont le courant de sortie de transformateur passe par la première entrée individuelle du dispositif de mesure qui détermine une première valeur de mesure de courant du courant continu,
**caractérisé en ce que**
le dispositif de mesure présente une seconde entrée individuelle à laquelle un second transformateur peut être raccordé, qui transforme le courant DC avec une plus grande précision que par le premier transformateur DC en un courant de sortie de transformateur proportionnel,
le second transformateur étant brièvement et temporairement disposé au même emplacement de mesure du conducteur que le premier transformateur DC et raccordé à la seconde entrée individuelle et capturant ainsi le même courant DC, de sorte que son courant en sortie de transformateur passe par la seconde entrée individuelle du dispositif de mesure qui détermine une seconde valeur de mesure de courant du courant DC, le dispositif de mesure utilisant les deux valeurs de mesure ainsi déterminées afin de déterminer un paramètre correctif, lorsque le second transformateur est raccordé à la seconde entrée individuelle du dispositif de mesure, et de sorte qu'une correction de la première valeur de mesure de courant mesurée soit effectuée au moyen du paramètre correctif quand le second transformateur est à nouveau éloigné du dispositif de mesure respectif après comparaison, de sorte que seul un unique second transformateur de plus grande précision de transformation soit nécessaire.
